# EUROPEAN PATENT SPECIFICATION

(11) **EP 4 539 119 B1**
(45) Date of publication and mention of the grant of the patent: **05.08.2026**
(21) Application number: 23202989.2
(22) Date of filing: 11.10.2023
(51) Int. Cl.: H10W 40/60, H10W 40/20

(54) **MOUNTING TOOL AND METHOD**
MONTAGEWERKZEUG UND VERFAHREN
OUTIL ET PROCÉDÉ DE MONTAGE

(43) Date of publication of application: 16.04.2025
(73) Proprietor: ABB Schweiz AG, 5400 Baden (CH)
(72) Inventor: Hakkarainen, Henri, 00380 Helsinki (FI); Varsila, Pauli, 00380 Helsinki (FI); Koivuluoma, Timo, 00380 Helsinki (FI)
(74) Representative: Kolster Oy Ab

(56) References cited:
- US-A1- 2004 076 408
- US-A1- 2005 160 592
- US-A1- 2023 282 539

## Description

### BACKGROUND OF THE INVENTION

### FIELD OF THE INVENTION

This invention relates to a mounting tool and to a method for connecting an electronic component to a cooling surface.

### DESCRIPTION OF PRIOR ART

Special attention is needed to deal with the heat generated by electronic components during use. If the heat is not handled in an adequate way and the temperature due to this rises too high, the electronic component may be damaged.

A well-known solution for dealing with heat from electronic components is to connect the component to a cooling surface, such as to a cooling surface of a heat sink, for instance. In this known solution the heat load from the electronic component is conducted to the cooling surface of the heat sink, from where the heat load is passed on to surroundings by dissipation, for instance.

One challenge to overcome in such a solution is to ensure that the heat transfer to the cooling surface is sufficiently efficient. This may be achieved by carefully cleaning the surfaces conducting the heat, and by arranging a Thermal Interface Material (TIM) foil between the surfaces, as disclosed, for example, in patent document US 2023/282539 A1. Thermal interface material foils are typically manufactured of materials which are very fragile and need to be handled with great care, so that the foil remains intact and can be placed correctly between the surfaces. Otherwise, the heat conducting properties of the thermal interface material foil may be reduced.

In praxis it has turned out that handling of thermal interface material foils is very challenging, in particular during service of devices. During service out at an installation site, the working conditions for handling fragile foils are often far from optimal. Additionally, if the foil is damaged during installation, it may be difficult or time consuming to obtain a new one for use at the installation site.

### SUMMARY OF THE INVENTION

An object of the present invention is to solve the above-mentioned drawback and to provide a mounting tool and a method which significantly simplifies installation work and reduces the risk of damaging the thermal interface material foil. This object is achieved with the mounting tool according to independent claim 1 and the method according to independent claim 7.

When the thermal interface material foil is arranged on a base surface of a mounting tool provided with spacers protruding from the base surface to contact the electronic component during the connection work, it becomes possible to connect the electronic component by screws or bolts to the cooling surface by threading these bolts or screws through first holes in the thermal interface material foil and notches provided in an outer edge of the mounting tool. In this way the thermal interface material foil can be initially fixed in exactly the correct position so that the mounting tool can be removed before the screws or bolts are finally tightened. This minimizes the risk of damaging the thermal interface material foil during the connecting, and also the risk that it becomes incorrectly positioned between the cooling surface and the electronic component.

Preferred embodiments of the invention are disclosed in the dependent claims.

### BRIEF DESCRIPTION OF DRAWINGS

In the following at least one embodiment of a mounting tool and a method for connecting will be described in closer detail by way of example and with reference to the attached drawings, in which:
Figure 1 illustrates a thermal interface material layer and a mounting tool,
Figure 2 illustrates the thermal interface material layer and the mounting tool of Figure 1 in a stacked connecting position with an electronic component,
Figure 3 illustrates the thermal interface material layer, the mounting tool and the electronic component in a stacked connecting position and connected to a cooling surface.

### DESCRIPTION OF AT LEAST ONE EMBODIMENT

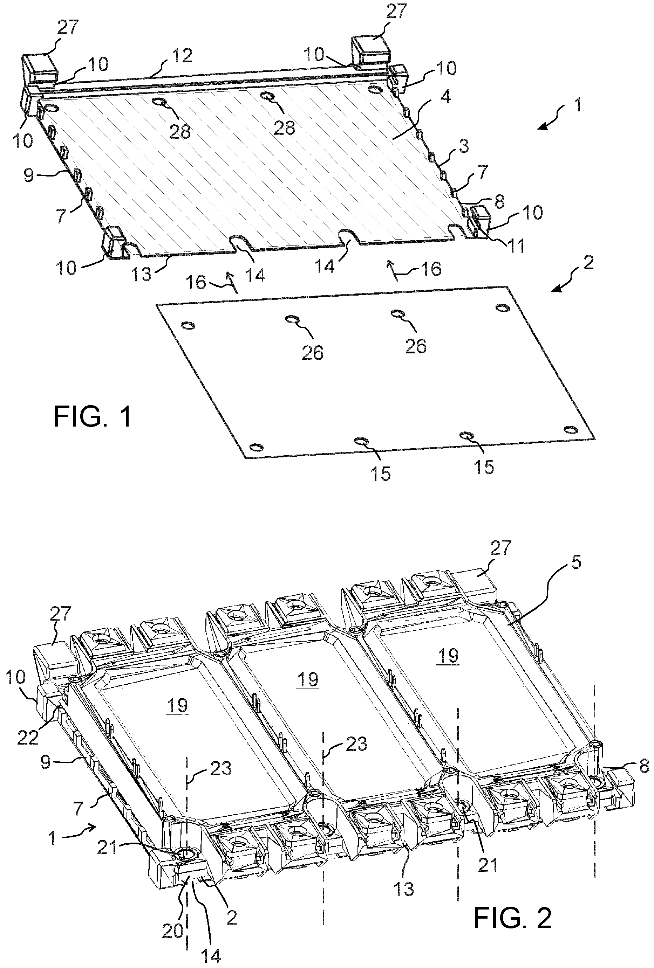

Figure 1 illustrates a mounting tool 1 and a thermal interface material layer 2. The mounting tool 1 may be manufactured of plastic, such as of PET (Polyethylene terephthalate) or PET-G (Polyethylene terephthalate glycol-modified), or of synthetic polymers with amide backbone, such as Nylon, or of PP (Polypropylene). The mounting tool may be manufactured by extrusion in a mold (in which case PET may be suitable) or alternatively by 3D printing (in which case PET-G may be suitable), for instance. A mounting tool may in praxis be provided as a separate part or alternative in a package together with an electronic component and a Thermal interface material foil, for instance. The mounting tool may be reused, if manufactured of a suitable material, such as PET, PP, Nylon or ABS, for instance, which facilitate efficient washing of the mounting tool after use. Preferably, the used material is relatively flexible, which makes it possible to bend the installation tool during removal of the tool, for instance. This may be advantageous in tight installation spaces.

The Thermal Interface Material (TIM) foil 2 may be a graphite sheet, for instance, which is very fragile, and which needs to be handled with care to avoid fingerprints or dirt from contaminating the foil. Industrial installation sites where Thermal interface material foils are installed are typically not so very clean environments. Naturally thermal interface material foils manufactured of other materials may be used. Several alternatives of thermal interface material foils are commercially available and suitable for use with the illustrated mounting tool 1 to implement the connecting method.

The mounting tool 1 comprises a base surface 3 with a reception area 4 dimensioned to receive the thermal interface material foil 2. In praxis the thermal interface material foil 2 is usually dimensioned to have a size and shape matching the size and shape of the electronic component 5 which will be connected to a cooling surface 6 with the mounting tool. In many implementations it is advantageous to dimension the thermal interface material foil 2 in such a way that it matches as closely as possible the outer boundaries of the electronic component 5. In this way it can be avoided that during and after the installation, the thermal insulation material foil 2 extends out from the space 20 between the cooling surface 6 and the electronic component 5, because this increases the risk of accidentally pulling or scraping the thermal interface material foil 2 in such a way that it becomes wrinkled or damaged.

In the illustrated example the base surface is by way of example illustrated as a mainly non-perforated surface. However, this is not necessary in all implementations. Instead, it is possible to provide one or more openings in the base surface, such as for reducing the amount of material needed to manufacture the mounting tool, for instance. Additionally, providing of such additional openings may be used to adjust the flexibility of the mounting tool according to the need.

As illustrated in particular in Figure 1, spacers 7 protrude from the base surface 3 on at least two sides of the reception area. In Figure 1 the spacers protrude substantially perpendicularly from the base surface 3 in order to contact the electronic component 5, which will be supported by these spacers. The spacers 7 are dimensioned to protrude a distance which is longer than the thickness of the thermal interface material foil 2. Due to this a space 20 will be provided between the electronic component and the base surface, which space is large enough to ensure that there is sufficient room between the electronic component and the mounting tool where the thermal interface material foil may be moved when needed. Naturally, in order to provide such a space, it is not necessary that the spacers protrude exactly perpendicularly from the base surface, but they may in some implementations be inclined in relation the base surface, for instance.

In the illustrated example, the spacers 7 are provided along a second edge 8 and a third edge 9 of the base surface 3. These edges are opposite edges which ensures that once the electronic component is supported by these spacers, the space 20 needed for the thermal interface foil 2 is obtained. In praxis it is not necessary that the spacers are arranged exactly at the edge, but instead they may be located at a distance from the edge, however, outside of the reception area 4 which is located between the opposite spacers. In many implementations only these spacers 3 are needed.

However, in the illustrated example additional support for the electronic component is provided by additional spacers 10 having slits 11 facing the reception area 4. In Figure 1 such spacers 10 with slits 11 can be seen along the second edge 8, third edge 9 and the fourth edge 12. These slits will receive sections of the electronic component 5 so that the electronic component can be provided to the mounting tool by a sliding movement controlled by the slits and the sections of the electronic component received into the slits.

The first outer edge 13 of the base surface 3 is provided with notches 14 which are open in a direction outwards from the reception area 4. These notches are provided in predetermined locations which have been selected for aligning with the first attachment holes 15 provided in the thermal interface material foil 2. Due to this, when the connecting method is implemented, and the thermal interface material foil 2 is arranged into a correct position of the reception area 4 of the base surface 3, in other words moved in the direction of arrows 16 in Figure 1, the first attachment holes 15 and the notches 14 will be located at the same positions. This makes it possible for screws or bolts 17 to pass through the first attachment holes 15 of the thermal interface material foil 2 and the notches 14 at the first outer edge 13 of the base surface 3.

Figure 2 illustrates the thermal interface material layer 2 and the mounting tool 1 of Figure 1 in a stacked connection position with an electronic component 5. The electronic component may consist of one single component only, in which case the mounting tool and the connecting method is implemented to connect this single component only to a cooling surface 6. However, in many practical implementations, as illustrated in the figures, the electronic component 5 may consist of several separate components 19 which are attached to each other, such as encapsulated in a housing or attached to a circuit board, for instance. In that case the electronic component 5 can be compared to a module, in which case the mounting tool and the connecting method is implemented for this module, so that all separate components 19 are simultaneously and at once connected to the cooling surface 6.

In praxis the electronic component 5 can be any type of electronic component generating heat during operation, and for which an efficient removal of generated heat is necessary. Examples of such electronic components include power electronics, such as power semiconductors and IGBT (Insulated-Gate Bipolar Transistor) modules, which may be found in frequency converters or other types of electric devices.

In Figure 2, the connection method has been implemented by arranging the electronic component 5 to contact the spacers 7, 10 protruding from the base surface 3, and by arranging the thermal interface material foil 2 to the reception area 4 of the base surface 3. The order in which these two steps have been implemented may vary from case to case.

In any case, in the example of Figure 2 the electronic component 5, the thermal material foil 2 and the mounting tool 1 are in the stacked connecting position, with the electronic component 5 illustrated to be on top, and the mounting tool 1 on the bottom. In this position the electronic component has sections 22 received into the slits 11 of the spacers 10, due to which the electronic component is fixed in a stable position to the mounting tool. This may be obtained by friction between the slits 11 and the sections 22, and additionally or alternatively, a snap fit attachment may be provided by bending parts of the mounting tool which is made of an elastic plastic material.

In Figure 2 screws or bolts 17 have not yet been provided. However, lines 23 illustrate the positions where these screws or bolts will be provided. Consequently, at the positions of the lines 23 the first attachment holes 21 in the electronic component 5, the first attachment holes 15 in the thermal interface material foil 2 and the notches 14 provided at the first outer edge 13 of the mounting tool 1 are aligned, to facilitate reception of the screws or bolts.

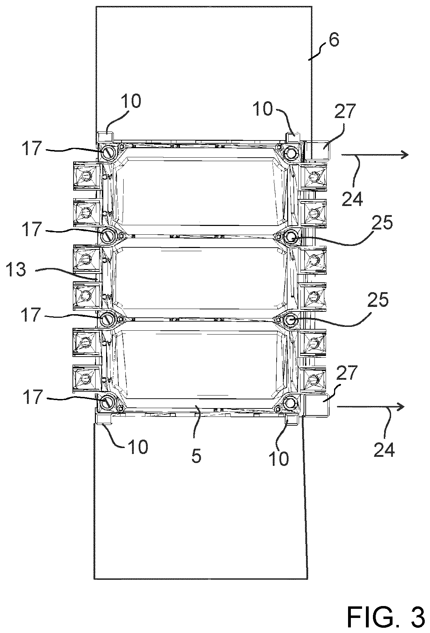

Figure 3 illustrates the thermal interface material layer, the mounting tool and the electronic component 5 in a stacked connection position of Figure 2, while connecting to the cooling surface 6.

The cooling surface 6 may be a surface of a heat sink or any other suitable cooling element capable of efficiently receiving and passing away a heat load from the electronic component 5.

Figure 3 illustrates an implementation where the cooling surface is in an upright vertical position. In prior art solutions it has been particularly problematic to provide a thermal interface material foil 2 between such a vertical surface and an electronic component, because it is very difficult to keep the thermal interface material foil 2 in the exactly correct position against the cooling surface or the electronic component during the work phase of attaching with screws or bolts.

However, with the mounting tool 1 this becomes significantly easier, as it becomes possible to arrange the electronic component 5, the thermal interface material foil 2 and the mounting tool 1 into the stacked connecting position already at an early stage, as has been explained and illustrated in connection with Figure 2. After that, with the thermal interface material foil 2 located in the space 20 between the base surface of the mounting tool 1 and the electronic component 5, the screws or bolts may be threaded through the first attachment holes 15, 21 and the notches 14 to keep the thermal interface material foil 2 in the exact correct position in the space 20, while the complete package is moved and turned into position where the mounting tool 1 contacts the vertical cooling surface 6, and the screws or bolts 17 can be attached to the cooling surface 6.

At that stage, the method step of removing the mounting tool 1 can be implemented before the screws or bolts 17 are finally tightened. The removal can be done by pulling the mounting tool out from the location between the cooling surface 6 and the thermal interface material foil 2, as illustrated by arrows 24 in Figure 3. Due to this pulling, the notches 14 at the first outer edge 13 of the base surface 3 move away from the screws or bolts 17. As no spacers or other obstacles are arranged to the first outer edge of the base surface, the pulling out is smooth and easy. Consequently, the mounting tool 1 is pulled away sideways in Figure 3, while the screws or bolts 17 keep the thermal interface material foil 2 and the electronic component 5 in place. After this the screws or bolts 17 can be finally tightened to ensure a good thermal connection between the cooling surface 6 and the electronical component 5 via the thermal interface material layer 2.

To still improve the connection, a second set of screws or bolts may be connected to the cooling surface 6 via second attachment holes 25 provided in the electronic component and via the second attachment holes 26 of the thermal interface material layer, which at that stage are aligned with each other.

In the illustrated example, though not necessary in all embodiments, the mounting tool 1 is provided with handle elements 27 which assist in the removal of the mounting tool 1. In the illustrated example these handle elements 27 have been implemented as parts protruding from the spacers 10 located in the corners of the second 8 and fourth 12 edges, and correspondingly third 9 and fourth 12 edges of the base surface 3 of the mounting tool. However, in other implementations, the locations of the handle elements 27 may be different. In any case, the handle elements 27 protrude outwards from the mounting tool 1 past the electronic component 5 in the stacked connecting position.

The reception area 4 of the base surface 3 is in the illustrated example provided with alignment holes 28, though such alignment holes are not necessary in all embodiments. In the stacked connecting position these alignment holes 28 are aligned with the second attachment holes 25 provided in the electronic component and with the second attachment holes 26 of the thermal interface material layer. This makes it possible to visually ensure that the position of the thermal interface material foil 2 is exactly correct when the connection to the cooling surface 26 is carried out.

It is to be understood that the above description and the accompanying figures are only intended to illustrate the present invention.

## Claims

1. Mounting tool (1) for connecting an electronic component (5) to a cooling surface (6) via a thermal interface material foil (2), **characterized in that** the mounting tool comprises:
a base surface (3) with a reception area (4) dimensioned to receive the thermal interface material foil (2),
spacers (7, 10) protruding from the base surface (3) on at least two sides of the reception area for contacting the electronic component, and
notches (14) provided at a first outer edge (13) of the base surface (3) at positions which are configured to be aligned with first attachment holes (15) provided in the
thermal interface material foil (2) for allowing screws or bolts (17) to pass through first attachment holes (15) of the thermal interface material foil (2) and the notches (14) when the electric component (5), the thermal interface material foil (2) and the mounting tool (1) are in a stacked connecting position.

2. The mounting tool according to claim 1, wherein the spacers (7, 10) are provided along at least a second (8) and a third edge (9) of the base surface (3) which are opposite edges of the base surface.

3. The mounting tool according to claim 1 or 2, wherein the mounting tool (1) comprises handle elements (27), which in the stacked connecting position, protrude outwards past the electronic component (5).

4. The mounting tool according to one of claims 1 to 3, wherein the base surface (3) comprises alignment holes (28) in the reception area (4) which in the stacked connecting position are aligned with second attachment holes (25) provided in the electronic component (5) and second attachment holes (26) provided in the thermal interface material foil (2) to allow visual observation of the position of the thermal interface material foil in relation to the electronic component and the mounting tool in the stacked connecting position.

5. The mounting tool according to one of claims 1 to 4, wherein one or more of the spacers (10) located on opposite sides of the reception area (4) are provided with slits (11) facing the reception area (4) for receiving sections (22) of the electronic component (5).

6. The mounting tool according to one of claims 1 to 5, wherein the mounting tool (1) is manufactured of a plastic material.

7. A method for connecting an electronic component to a cooling surface via a thermal interface material foil, **characterized in that** the method comprises:
arranging the electronic component (5) to contact spacers (7, 10) protruding from a base surface of the mounting tool,
arranging the thermal interface material foil (2) to a reception area (4) of the base surface (3), before or after said arranging of the electronic component,
connecting, when the thermal interface material (2) foil is in a space (20) between the base surface (3) and the electronic component (5), the electronic component (5) to the cooling surface (6) by screws or bolts (17) extending through first attachment holes (21) in the electronic component (5), through first attachment holes (15) in the thermal interface material foil (2) and through notches (14) provided at a first outer edge (13) of the base surface (3) when the electric component (5), the thermal interface material (2) and the mounting tool (1) are in a stacked connecting position, and
removing the mounting tool (1) by pulling it out from the location between the cooling surface (6) and the thermal interface material foil (2) such that the notches (14) at the first outer edge (13) of the base surface (3) move away from the screws or bolts (17) before final tightening of the screws or bolts.

8. The method according to claim 7, wherein the electronic component (5) is arranged to contact the spacers (7, 10) by sliding it in a direction parallel to the base surface (3) such that sections (22) of the electronic component (5) are received in slits (11) facing the reception area (4) which are provided in at least some of the spacers (10).

9. The method according to claim 7 or 8, wherein the mounting tool (1) is removed by pulling it out in a direction parallel to the base surface (3) with handles (27) protruding out from the base surface (3) past the electronic component (5).

## Patentansprüche

1. Montagewerkzeug (1) zum Verbinden einer elektronischen Komponente (5) mit einer Kühlfläche (6) über eine Wärmeleitfolie (2), **dadurch gekennzeichnet, dass** das Montagewerkzeug Folgendes umfasst:
eine Grundfläche (3) mit einem Aufnahmebereich (4), der zum Aufnehmen der Wärmeleitfolie (2) dimensioniert ist, Abstandhalter (7, 10), die auf mindestens zwei Seiten des Aufnahmebereichs von der Grundfläche (3) vorstehen, um die elektronische Komponente zu berühren, und
Kerben (14), die an einer ersten Außenkante (13) der Grundfläche (3) an Positionen vorgesehen sind, die dazu ausgelegt sind, mit ersten Befestigungsbohrungen (15), die in der Wärmeleitfolie (2) vorgesehen sind, ausgerichtet zu sein, um zuzulassen, dass Schrauben oder Bolzen (17) durch erste Befestigungsbohrungen (15) der Wärmeleitfolie (2) und die Kerben (14) hindurchgehen, wenn sich die elektrische Komponente (5), die Wärmeleitfolie (2) und das Montagewerkzeug (1) in einer gestapelten Verbindungsposition befinden.

2. Montagewerkzeug nach Anspruch 1, wobei die Abstandhalter (7, 10) entlang zumindest einer zweiten (8) und einer dritten Kante (9) der Grundfläche (3) vorgesehen sind, die gegenüberliegende Kanten der Grundfläche sind.

3. Montagewerkzeug nach Anspruch 1 oder 2, wobei das Montagewerkzeug (1) Griffelemente (27) umfasst, die in der gestapelten Verbindungsposition nach außen über die elektronische Komponente (5) vorstehen.

4. Montagewerkzeug nach einem der Ansprüche 1 bis 3, wobei die Grundfläche (3) Ausrichtungsbohrungen (28) im Aufnahmebereich (4) umfasst, die in der gestapelten Verbindungsposition mit zweiten Befestigungsbohrungen (25), die in der elektronischen Komponente (5) vorgesehen sind, und zweiten Befestigungsbohrungen (26), die in der Wärmeleitfolie (2) vorgesehen sind, ausgerichtet sind, um eine visuelle Beobachtung der Position der Wärmeleitfolie in Bezug zur elektronischen Komponente und zum Montagewerkzeug in der gestapelten Verbindungsposition zuzulassen.

5. Montagewerkzeug nach einem der Ansprüche 1 bis 4, wobei einer oder mehrere der Abstandhalter (10), die sich auf gegenüberliegenden Seiten des Aufnahmebereichs (4) befinden, mit Schlitzen (11) versehen sind, die dem Aufnahmebereich (4) zugewandt sind, um Abschnitte (22) der elektronischen Komponente (5) aufzunehmen.

6. Montagewerkzeug nach einem der Ansprüche 1 bis 5, wobei das Montagewerkzeug (1) aus einem Kunststoffmaterial hergestellt ist.

7. Verfahren zum Verbinden einer elektronischen Komponente mit einer Kühlfläche über eine Wärmeleitfolie, **dadurch gekennzeichnet, dass** das Verfahren Folgendes umfasst:
Anordnen der elektronischen Komponente (5), um Abstandhalter (7, 10) zu berühren, die von einer Grundfläche des Montagewerkzeugs vorstehen,
Anordnen der Wärmeleitfolie (2) an einem Aufnahmebereich (4) der Grundfläche (3) vor oder nach dem Anordnen der elektronischen Komponente,
wenn sich die Wärmeleitfolie (2) in einem Raum (20) zwischen der Grundfläche (3) und der elektronischen Komponente (5) befindet, Verbinden der elektronischen Komponente (5) mit der Kühlfläche (6) mittels Schrauben oder Bolzen (17), die sich durch erste Befestigungsbohrungen (21) in der elektronischen Komponente (5), durch erste Befestigungsbohrungen (15) in der Wärmeleitfolie (2) und durch Kerben (14), die an einer ersten Außenkante (13) der Grundfläche (3) vorgesehen sind, erstrecken, wenn sich die elektrische Komponente (5), die Wärmeleitfolie (2) und das Montagewerkzeug (1) in einer gestapelten Verbindungsposition befinden, und
Entfernen des Montagewerkzeugs (1) durch Herausziehen aus der Stelle zwischen der Kühlfläche (6) und der Wärmeleitfolie (2), so dass sich die Kerben (14) an der ersten Außenkante (13) der Grundfläche (3) von den Schrauben oder Bolzen (17) weg bewegen, bevor die Schrauben oder Bolzen endgültig angezogen werden.

8. Verfahren nach Anspruch 7, wobei die elektronische Komponente (5) dazu angeordnet ist, die Abstandhalter (7, 10) zu berühren, indem sie in eine Richtung parallel zur Grundfläche (3) verschoben wird, so dass Abschnitte (22) der elektronischen Komponente (5) in Schlitzen (11) aufgenommen werden, die dem Aufnahmebereich (4) zugewandt sind, die in zumindest einigen der Abstandhalter (10) vorgesehen sind.

9. Verfahren nach Anspruch 7 oder 8, wobei das Montagewerkzeug (1) entfernt wird, indem es in eine Richtung parallel zur Grundfläche (3) herausgezogen wird, wobei Griffe (27) von der Grundfläche (3) über die elektronische Komponente (5) vorstehen.

## Revendications

1. Outil de montage (1) destiné à connecter un composant électronique (5) à une surface de refroidissement (6) par l'intermédiaire d'une feuille de matériau d'interface thermique (2), **caractérisé en ce que** l'outil de montage comprend :
une surface de base (3) dotée d'une zone de réception (4) dimensionnée pour recevoir la feuille de matériau d'interface thermique (2),
des entretoises (7, 10) faisant saillie de la surface de base (3) sur au moins deux côtés de la zone de réception pour entrer en contact avec le composant électronique, et
des encoches (14) situées au niveau d'un premier bord extérieur (13) de la surface de base (3) à des positions qui sont prévues pour être alignées avec des premiers trous de fixation (15) ménagés dans la feuille de matériau d'interface thermique (2) pour permettre le passage de vis ou de boulons (17) à travers des premiers trous de fixation (15) de la feuille de matériau d'interface thermique (2) et les encoches (14) lorsque le composant électrique (5), la feuille de matériau d'interface thermique (2) et l'outil de montage (1) se trouvent dans une position de connexion empilée.

2. Outil de montage selon la revendication 1, les entretoises (7, 10) étant situées le long d'au moins un deuxième bord (8) et un troisième bord (9) de la surface de base (3) qui sont des bords opposés de la surface de base.

3. Outil de montage selon la revendication 1 ou 2, l'outil de montage (1) comprenant des éléments de poignée (27) qui, dans la position de connexion empilée, font saillie vers l'extérieur au-delà du composant électronique (5).

4. Outil de montage selon l'une des revendications 1 à 3, la surface de base (3) comprenant des trous d'alignement (28) dans la zone de réception (4) qui, dans la position de connexion empilée, sont alignés avec des seconds trous de fixation (25) ménagés dans le composant électronique (5) et des seconds trous de fixation (26) ménagés dans la feuille de matériau d'interface thermique (2) pour permettre l'observation visuelle de la position de la feuille de matériau d'interface thermique par rapport au composant électronique et à l'outil de montage dans la position de connexion empilée.

5. Outil de montage selon l'une des revendications 1 à 4, une ou plusieurs des entretoises (10) situées sur des côtés opposés de la zone de réception (4) étant pourvues de fentes (11) tournées vers la zone de réception (4) pour recevoir des sections (22) du composant électronique (5).

6. Outil de montage selon l'une des revendications 1 à 5, l'outil de montage (1) étant fabriqué en matière plastique.

7. Procédé de connexion d'un composant électronique à une surface de refroidissement par l'intermédiaire d'une feuille de matériau d'interface thermique, **caractérisé en ce que** le procédé comprend les étapes consistant à :
mettre en place le composant électronique (5) pour entrer en contact avec des entretoises (7, 10) faisant saillie depuis une surface de base de l'outil de montage, mettre en place la feuille de matériau d'interface thermique (2) sur une zone de réception (4) de la surface de base (3), avant ou après ladite mise en place du composant électronique,
connecter, lorsque la feuille du matériau d'interface thermique (2) se trouve dans un espace (20) entre la surface de base (3) et le composant électronique (5), le composant électronique (5) à la surface de refroidissement (6) par des vis ou des boulons (17) s'étendant au travers des premiers trous de fixation (21) dans le composant électronique (5), à travers des premiers trous de fixation (15) dans la feuille de matériau d'interface thermique (2) et à travers des encoches (14) situées au niveau d'un premier bord extérieur (13) de la surface de base (3) lorsque le composant électrique (5), le matériau d'interface thermique (2) et l'outil de montage (1) sont dans une position de connexion empilée, et
retirer l'outil de montage (1) en le tirant hors de l'emplacement entre la surface de refroidissement (6) et la feuille de matériau d'interface thermique (2) de sorte que les encoches (14) au niveau du premier bord extérieur (13) de la surface de base (3) s'éloignent des vis ou boulons (17) avant le serrage final des vis ou boulons.

8. Procédé selon la revendication 7, le composant électronique (5) étant conçu pour venir en contact avec les entretoises (7, 10) en étant glissé dans une direction parallèle à la surface de base (3) de sorte que des sections (22) du composant électronique (5) soient reçues dans des fentes (11) tournées vers la zone de réception (4) qui sont situées dans au moins certaines des entretoises (10).

9. Procédé selon la revendication 7 ou 8, l'outil de montage (1) étant retiré en étant tiré dans une direction parallèle à la surface de base (3) avec des poignées (27) faisant saillie de la surface de base (3) au-delà du composant électronique (5).
